# EUROPÄISCHE PATENTSCHRIFT

(11) **EP 2 104 611 B1**
(45) Veröffentlichungstag und Bekanntmachung des Hinweises auf die Patenterteilung: **12.05.2010**
(21) Anmeldenummer: 07821062.2
(22) Anmeldetag: 09.10.2007
(51) Int. Cl.: B32B 27/28, B32B 17/10, H01L 31/0203

(54) **LAMINATE MIT THERMOPLASTISCHEN POLYSILOXAN-HARNSTOFF-COPOLYMEREN**
LAMINATES COMPRISING THERMOPLASTIC POLYSILOXANE UREA COPOLYMERS
STRATIFIÉS COMPORTANT DES COPOLYMÈRES THERMOPLASTIQUES D'URÉE ET DE POLYSILOXANE

(30) Priorität: 11.10.2006 DE 102006048216
(43) Veröffentlichungstag der Anmeldung: 30.09.2009
(73) Patentinhaber: Wacker Chemie AG, 81737 München (DE)
(72) Erfinder: OCHS, Christian, 84489 Burghausen (DE); HIEMEYER, Ralph, 81479 München (DE); SCHÄFER, Oliver, 84489 Burghausen (DE)
(74) Vertreter: Budczinski, Angelika
(86) Internationale Anmeldenummer: PCT/EP2007/060693
(87) Internationale Veröffentlichungsnummer: WO 2008/043749

(56) Entgegenhaltungen:
- DE-U1- 20 220 444
- US-A- 4 057 439
- US-A- 4 322 261
- US-B1- 6 340 403

## Beschreibung

Gegenstand der Erfindung sind Laminate, bei denen mindestens eine Schicht thermoplastische Polysiloxan-Harnstoff-Copolymere sowie mindestens eine weitere Schicht einer oder mehrerer Solarzelleneinheiten enthalten ist, ein Verfahren zu deren Herstellung und ihre Verwendung.

Als Laminat (lat. lamina: Schicht) wird im Allgemeinen ein mehrlagiger Werkstoff bezeichnet, der durch Laminieren, also Verpressen und gleichzeitigem Verkleben, mindestens zweier Lagen gleicher oder verschiedener Materialien entsteht. Glaslaminate sind seit langer Zeit bekannt und haben einen weiten Einsatzbereich als sogenannte Verbundsicherheitsgläser im Automobil-, Fahrzeug- und Flugzeugbau sowie in der Bauindustrie. Verbundglas ist sandwichartig aufgebaut und besteht aus mindestens einer Glastafel und einer darauf befindlichen polymeren Schicht. Am häufigsten wird als polymere Zwischenschicht weichgemachtes Polyvinylbutyral (PVB) in Folienform verwendet. Des Weiteren kann die Zwischenschicht auch aus Polyurethan oder Polyacrylat bestehen oder aus einer Kombination mehrerer verschiedener Werkstoffe.

Photovoltaische Solarmodule sind Laminate, welche einen den Verbundgläsern ähnlichen, schichtartigen Aufbau aufweisen, zusätzlich aber mindestens eine photosensitive Halbleiterschicht, welche in geeigneter Weise über Kontaktierungsbahnen zu einer oder mehreren photovoltaischen Zellen (im folgenden "Solarzelleneinheiten" genannt) verschaltet ist, enthalten. Laminate derartigen Aufbaus sind im allgemeinen Sprachgebrauch auch unter den Begriffen "photovoltaisches Modul", "Solarzellenmodul", "Solarmodul", "Solarpaneel" oder ähnlichem bekannt. Hierzu sei z.B. auf Ullmanns's Encyclopedia Of Industrial Chemistry, 5. Auflage, 1992, Vol. A24, Seiten 393-395 verwiesen.

Ein photovoltaisches Solarmodul besteht in der Regel aus einer oder mehreren, miteinander verschalteten Solarzelleneinheiten, die zum Schutz gegen äußere Einflüsse mit einer transparenten Schutzabdeckung versehen werden. Hierbei sind die Solarzelleneinheiten häufig zwischen eine Glasscheibe und eine mehr oder weniger rigide, hintere Abdeckplatte, die ebenfalls aus Glas oder organischen Polymeren/Copolymeren, wie z.B. solchen auf Basis von Polyvinylfluorid (PVF) oder Polyethylenterephthalat (PET), bestehen kann, mit Hilfe einer transparenten Klebeschicht laminiert (starres Solarmodul). Daneben sind auch flexible Solarmodule bekannt, die in gewissen Grenzen biegbar sind. Bei diesen besteht die vordere, schützende Deckschicht beispielsweise aus transparenten organischen (Co)Polymeren, während die hintere Abdeckplatte aus einer dünnen Metall- oder Kunstoffplatte bzw. einem geeigneten Kompositmaterial auf Kunststoff- und/oder Metallbasis besteht.

Die zur Laminierung benötigte transparente Klebeschicht besitzt mehrere Aufgaben, die Anforderungen an die verwendeten Materialien sind dementsprechend hoch. So fungiert die Klebeschicht zum einen als schützendes Einbettmaterial für die äußerst empfindlichen Solarzelleneinheiten, indem sie diese vollständig umschließt und gegen äußere Einflüsse, wie z.B. das Eindringen von Feuchtigkeit und Sauerstoff, weitgehend isoliert. Gleichzeitig darf sie jedoch die optischen Eigenschaften der photosensitiven Materialien nicht beeinträchtigen. Weiterhin muss das verwendete Einbettmaterial über Jahrzehnte hinweg hochtransparent und UV-stabil sein, sowie den dauerhaften Zusammenhalt des sandwichartigen Materialverbundes über die gesamte Lebensdauer des photovoltaischen Solarmoduls garantieren. Weitere Anforderungen sind einfache Verarbeitbarkeit, gute Haftung auf den relevanten Substraten sowie hohe Transparenz und Blasenfreiheit nach dem Laminierschritt.

Als transparentes Klebe- oder Einbettmaterial werden häufig organische Gießharze, z.B. auf der Basis von Polyurethanen, Polyestern, Polycarbonaten, Epoxiden und Acrylaten sowie vernetzbaren, Silicon-basierenden Systemen, wie z.B. Silicongele, eingesetzt. Diese Klebesysteme können im ungehärteten Zustand so niederviskos eingestellt werden, dass auch kleinste Kavitäten vollständig gefüllt und die Solarzelleneinheiten blasenfrei umschlossen werden. Durch bereits im Klebesystem enthaltene bzw. zusätzlich hinzuzugebende Härter oder Vernetzungsmittel wird dann eine Vulkanisation induziert, und man erhält eine mechanisch widerstandsfähige Klebeschicht.

Nachteilig an den genannten Einbettmaterialien ist die aufwändige Herstellung entsprechender Solarmodule, da der Laminierschritt den Umgang mit Mehrkomponentensystemen und eine hohe Sorgfalt beim Einlegen bzw. Verguss der Solarzelleneinheiten erfordert; dies gilt insbesondere bei großflächigen Elementen. Bei den organischen Gießharzsystemen ist darüberhinaus die Aushärtung ein schwierig zu kontrollierender Prozess. Zudem neigen einige der Gießharze nach Jahren zur Blasenbildung, Eintrübung oder Delaminierung.

Eine Alternative zu aushärtenden Systemen ist - in Analogie zur Herstellung von Verbundsicherheitsglas - der Einsatz von auf organischen Polymeren oder Copolymeren, insbesondere auf Polyvinylbutyral (PVB) oder Ethylen-Vinylacetat (EVA) basierenden, thermoplastischen Folien. Hierzu werden die Solarzelleneinheiten zwischen den Polymerfolien eingebettet und dann unter erhöhtem Druck und erhöhter Temperatur mit den gewünschten Abdeckmaterialien zu einem Laminat verbunden. Die Verwendung thermoplastischer EVA- oder PVB-Folien ist jedoch mit einigen Nachteilen verbunden, die sich sowohl auf die Qualität als auch auf die Herstellkosten von photovoltaischen Solarmodulen negativ auswirken.

Das im Solarmodulbau weit verbreitete EVA enthält organische Peroxide, um während des Laminierungsschrittes das originär thermoplastische Material nachträglich zu vernetzen und somit die Kriechfestigkeit des Einbettmaterials deutlich zu verbessern. Das Peroxid wird während des Laminierens jedoch oftmals nicht vollständig aufgebraucht, so dass etwaig überschüssiges Peroxid eine spätere Oxidation oder Zersetzung, insbesondere aber die Vergilbung des EVA begünstigen kann. So ist beispielsweise bekannt, dass mit Peroxid nachträglich vernetztes EVA unter jahrelangem, extensiven Einfluss von Sonnenlicht, wie er etwa beim Betrieb von Solarmodulen im Freien auftritt, gelb wird. Dies führt jedoch zu einer schleichenden Abnahme der Solarenergieausbeute des Moduls. Weiterhin muss der Laminierschritt wegen der parallel verlaufenden, peroxidisch induzierten Nachvernetzung im Vakuum erfolgen. Die Ursache hierfür liegt in der Tatsache begründet, dass Luftsauerstoff die radikalisch verlaufenden Vernetzungsreaktionen negativ beeinflusst und den Vernetzungsgrad, und damit die Kriechfestigkeit des nachvernetzten EVA, herabsetzt. Die organischen Peroxide wiederum sind, ebenso wie ihre Spalt- und Abbauprodukte, verhältnismäßig reaktive Verbindungen, die oftmals zu einem vorzeitigen Verschleiß der in den EVA-Laminierapparaturen enthaltenen Membranen führen. Zusätzlich kann EVA unter Herstellungsbedingungen geringe Mengen Essigsäure freisetzen, die dann in der Folge die Metallkontaktkorrosion in den Solarzelleneinheiten fördern kann. Zusätzlich führen das Aufschmelzen, das relativ langsame Vernetzen des EVA sowie die Laminierung des Materialverbunds bei etwa 150°C und unter Vakuum zu Zyklenzeiten von etwa 15 bis 30 Minuten pro Modul.

Das zu Beginn der Entwicklung des Solarmodulbaus weit verbreitete PVB weist ebenfalls einen gravierenden Nachteil auf: PVB ist bekanntermaßen extrem hygroskopisch und neigt stark zur Feuchtigkeitsaufnahme. Es muss daher bis zum Laminierungsschritt unter definierten, klimatischen Bedingungen gelagert werden. Weiterhin weiß man aufgrund negativer Erfahrungen aus dem Verbundglasbereich, dass PVB auch im laminierten Zustand langsam Feuchtigkeit aufnehmen kann und sich dabei mehr oder weniger stark eintrübt. Die Eintrübung wiederum verringert die Lichtdurchlässigkeit der Laminatschicht bedeutend, so dass in einem solchen Fall die Solarenergieausbeute des Moduls merklich reduziert wird. Um also den Einfluss der Luftfeuchtigkeit auf das Laminiermedium für die vollständige Lebensdauer des Solarmoduls möglichst gering zu halten, sind spezielle Dichtsysteme oder zusätzliche Randabdichtungen mit anderen Dichtstoffen erforderlich. Dies macht den Bau entsprechender Solarmodule aufwändig und kostenintensiv.

Als Alternative zu PVB wurde ein thermoplastisches Polyurethansystem (TPU) beschrieben, welches sich ähnlich einfach wie PVB verarbeiten lässt, gleichzeitig aber nicht die vom PVB bekannten, oben geschilderten Probleme aufweisen soll. Hierzu sei auf DE 20220444 U1 verwiesen. Bei den verwendeten thermoplastischen Polyurethanen handelt es sich um Reaktionsprodukte von aliphatischen Diisociyanaten mit organischen Polyolen, wobei ggf. zusätzliche Kettenverlängerer auf Basis von organischen Polyolen zugegen sein können. Nachteilig an dem beschriebenen Klebesystem ist jedoch die Verwendung rein organischer Synthesebausteine, was eine reduzierte Langzeit-UV-Stabilität mit sich bringt und somit die Zugabe zusätzlicher UV-Stabilisatoren erforderlich macht. Das wiederum führt - im Übrigen ebenso wie bei EVA - zu einer verminderten Transparenz der Laminate im hochfrequenten sichtbaren sowie UV-A- und UV-B-Bereich, der insbesondere für nicht auf Silizium basierende Solarzellen von Interesse ist. Des Weiteren ist die Verwendung organischer Polyole als Synthesebaustein ungünstig, da diese Verbindungen bekanntermaßen polar und hydrophil sind, was einer Wirkung als Wasserdampfdiffusionssperre und damit einer Langzeitwitterungsstabilität der offenbarten Laminate entgegensteht. Ferner weist die verwendete Substanzklasse der TPUs einen relativ hohen Glasübergangspunkt und damit eine begrenzte Flexibilität, insbesondere bei niedrigen Temperaturen, auf. Da der E-Modul in der Nähe des Glasübergangspunkts aber stark temperaturabhängig ist, kann dies dazu führen, dass beim Betrieb eines solchen Solarmoduls bei niedriger Außentemperatur (z.B. unter 0°C) die Klebeschicht stark verstrammt und die zerbrechlichen Solarzellen sowie die Verbindungsleiter in Mitleidenschaft gezogen werden, was bis zum Totalausfall des Moduls oder beginnender Delamination führen kann.

Gegenstand der Erfindung ist ein Laminat umfassend
(A) mindestens eine Schicht enthaltend anorganisches und/oder organisches Glas,
(B) mindestens eine Schicht enthaltend ein thermoplastisches Siloxancopolymer,
(C) mindestens eine Einheit enthaltend mindestens eine photosensitive Schicht,
   und gegebenenfalls
(D) mindestens eine weitere Schicht ausgewählt aus der Gruppe enthaltend organische Polymere, siliciumorganische Polymere, metallische Werkstoffe, mineralische Werkstoffe und Holz.

Anorganisches oder organisches Glas (A) im Sinne der vorliegenden Erfindung sind gehärtete und ungehärtete Mineralgläser sowie organische Gläser auf Basis transparenter organischer Polymere und Copolymere.

Beispiele für Mineralgläser sind technische Gläser, wie Quarzglas, Kalknatronglas, Borosilicatglas, Alumosilicatglas, Bleiboratglas, Floatglas, Einscheibensicherheitsglas und teilvorgespanntes Glas sowie glaskeramische Gläser. Weitere Beispiele sind die in Ullmanns's Encyclopedia Of Industrial Chemistry, 5. Auflage, 1991, Vol. A18, Seite 201-202 für optische Gläser genannten Beispiele, die zum Offenbarungsgehalt der vorliegenden Anmeldung zu zählen sind.

Beispiele für organisches Glas sind Gläser bestehend aus Polycarbonat, Acrylglas, wie z.B. solches erhältlich unter der Marke Plexiglas^{®} bei der Degussa AG, Deutschland, Polyester, Polyamid, Polystyrol, Polyacrylate, Polymethylmethacrylate, PVC, Polypropylen, Polyethylen, Polyethylentherephthalat, Polymeren auf Basis fluorierter Kohlenwasserstoffe, wie zum Beispiel solche erhältlich unter der Marke Fluon^{®} bei der Asahi Glass Co., Ltd., Japan, sowie Copolymere aus den genannten Polymeren. Weitere Beispiele sind die in Ullmanns's Encyclopedia Of Industrial Chemistry, 5. Auflage, 1991, Vol. A18, Seite 204-205 genannten Beispiele für optische Gläser auf Basis von organische Polymeren, die zum Offenbarungsgehalt der vorliegenden Anmeldung zu zählen sind.

Die erfindungsgemäß eingesetzten Gläser (A) haben bei 25°C einen Wärmeausdehnungskoeffizienten von bevorzugt -1*10⁻⁶ bis 100*10⁻⁵ K⁻¹, insbesondere von 0 bis 100*10⁻⁶ K⁻¹.

Bevorzugt handelt es sich bei den erfindungsgemäß eingesetzten Gläsern (A) um hochtransparente Materialien, also um Gläser mit einem Transmissionsgrad _{D65} (gemäß DIN 5036, Teil 3) von mindestens 80 %, besonders bevorzugt von mindestens 85 %, insbesondere bevorzugt von mindestens 90 %.

Die erfindungsgemäß eingesetzten Gläser weisen vorzugsweise einen Schmelzpunkt bzw. Erweichungspunkt von über 60°C, besonders bevorzugt von über 80°C auf, jeweils beim Druck der umgebenden Atmosphäre, also 900 bis 1100 hPa.

Das anorganische oder organische Glas kann gemäß der vorliegenden Erfindung in Platten-, Tafel- oder Folienform vorliegen. Es kann sich auch um Colaminate verschiedener Gläser (A) handeln. Vorzugsweise besteht die Schicht (A) aus einer Platte oder aus einer oder mehreren Folien.

Die Schicht (A) kann aus einem einheitlichen Material bestehen oder auch selbst mehrschichtig aufgebaut sein. Beispiele für einen mehrlagigen Schichtaufbau von (A) ist die Ausführung des anorganischen Glases (A) als Verbundsicherheitsglas oder als entspiegeltes Floatglas.

Das anorganische oder organische Glas kann - falls erwünscht - oberflächenbehandelt sein, beispielsweise, um die mechanische Beständigkeit der Schicht (A) zu verbessern oder um Ausbeuteverluste durch Lichtreflexion bzw. durch übermäßige Erwärmung des Moduls zu verringern. Beispiele für Oberflächenbehandlungen sind das Aufbringen einer Antikratz- und/oder einer Antireflexschicht, wie z.B. in US 2005/0074591 A1, EP 1328483 B1, DE 10250564 A1 und DE 10342401 A1 beschrieben, einer Schicht, die zu einem Selbstreinigungseffekt führt, die antistatische Ausrüstung, wie in DE 19963866 A1 beschrieben, das Aufbringen einer Anti-Beschlag-Beschichtung, wie in DE 102004053708 A1 beschrieben, oder die Veränderung der Oberflächenrauigkeit.

Bei den erfindungsgemäß eingesetzten thermoplastischen Siloxancopolymeren kann es sich um beliebige, bisher bekannte thermoplastische Verbindungen handeln.

Bei dem thermoplastischen Siloxancopolymer der Schicht (B) handelt es sich bevorzugt um Verbindungen der allgemeinen Formel 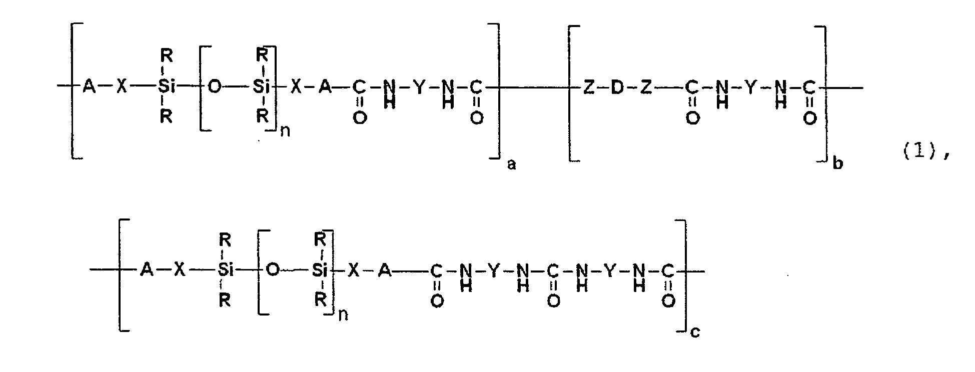 wobei
- R: gleich oder verschieden sein kann und einen einwertigen, Sigebundenen, gegebenenfalls durch Halogenatome substituierten Kohlenwasserstoffrest, der durch Sauerstoffatome unterbrochen sein kann, darstellt,
- X: gleich oder verschieden sein kann und einen Alkylenrest mit 1 bis 20 Kohlenstoffatomen, in dem einander nicht benachbarte Methyleneinheiten durch Gruppen -O- ersetzt sein können, bedeutet,
- A: gleich oder verschieden sein kann und ein Sauerstoffatom oder eine Aminogruppe -NR'- bedeutet,
- Z: gleich oder verschieden sein kann und ein Sauerstoffatom oder eine Aminogruppe -NR'- bedeutet,
- R': gleich oder verschieden sein kann und Wasserstoffatom oder einen Alkylrest mit 1 bis 10 Kohlenstoffatomen bedeutet,
- Y: gleich oder verschieden sein kann und einen zweiwertigen, gegebenenfalls durch Halogenatome substituierten Kohlenwasserstoffrest mit 1 bis 20 Kohlenstoffatomen, der durch Sauerstoffatome unterbrochenen sein kann, bedeutet,
- D: gleich oder verschieden sein kann und einen zweiwertigen, gegebenenfalls durch Halogenatome oder C₁-C₆-Alkylester-Gruppen substituierten Kohlenwasserstoffrest bedeutet, in dem einander nicht benachbarte Methyleneinheiten durch Gruppen -O-, -COO-, -OCO- oder -OCOO- ersetzt sein können,
- n: gleich oder verschieden sein kann und eine Zahl von 1 bis 4000 ist,
- a: eine Zahl von mindestens 1 ist,
- b: 0 oder eine Zahl von 1 bis 1000 ist und
- c: 0 oder eine Zahl von 1 bis 1000 ist.

Beispiele für R sind Alkylreste, wie der Methyl-, Ethyl-, n-Propyl-, iso-Propyl-, 1-n-Butyl-, 2-n-Butyl-, iso-Butyl-, tert.-Butyl-, n-Pentyl-, iso-Pentyl-, neo-Pentyl-, tert.-Pentylrest; Hexylreste, wie der n-Hexylrest; Heptylreste, wie der n-Heptylrest; Octylreste, wie der n-Octylrest und iso-Octylreste, wie der 2,2,4-Trimethylpentylrest; Nonylreste, wie der n-Nonylrest; Decylreste, wie der n-Decylrest; Dodecylreste, wie der n-Dodecylrest; Octadecylreste, wie der n-Octadecylrest; Cycloalkylreste, wie der Cyclopentyl-, Cyclohexyl-, Cycloheptylrest und Methylcyclohexylreste; Alkenylreste, wie der Vinyl-, 1-Propenyl- und der 2-Propenylrest; Arylreste, wie der Phenyl-, Naphthyl-, Anthryl- und Phenanthrylrest; Alkarylreste, wie o-, m-, p-Tolylreste; Xylylreste und Ethylphenylreste; und Aralkylreste, wie der Benzylrest, der der α- und der β-Phenylethylrest.

Beispiele für halogenierte Reste R sind Halogenalkylreste, wie der 3,3,3-Trifluor-n-propylrest, der 2,2,2,2',2',2'-Hexafluorisopropylrest, der Heptafluorisopropylrest und Halogenarylreste, wie der o-, m- und p-Chlorphenylrest.

Vorzugsweise bedeutet Rest R einen einwertigen gegebenenfalls mit Fluor- und/oder Chloratomen substituierten Kohlenwasserstoffrest mit 1 bis 20 Kohlenstoffatomen, besonders bevorzugt einen Kohlenwasserstoffrest mit 1 bis 6 Kohlenstoffatomen, insbesondere Methyl-, Ethyl-, Vinyl- und Phenylrest.

Beispiele für Rest X sind die unten für Rest Y angegebenen Alkylenreste.

Vorzugsweise handelt es sich bei Rest X um einen Alkylenrest mit 1 bis 10 Kohlenstoffatomen, besonders bevorzugt um den Methylen- und n-Propylenrest.

Bevorzugt handelt es sich bei Rest R' um Wasserstoffatom.

Vorzugsweise bedeutet A einen Rest -NR'- mit R' gleich der oben genannten Bedeutung, besonders bevorzugt einen Rest -NH-.

Vorzugsweise hat Rest Z die Bedeutung von -O- oder -NH-.

Beispiele für Rest Y sind Alkylenreste, wie der Methylen-, Ethylen-, n-Propylen-, iso-Propylen-, n-Butylen-, iso-Butylen-, tert.-Butylen-, n-Pentylen-, iso-Pentylen-, neo-Pentylen-, tert.-Pentylenrest, Hexylenreste, Heptylenreste, Octylenreste, Nonylenreste, Decylenreste, Dodecylenreste und Octadecylenreste; Cycloalkylenreste, wie Cyclopentylenrest, 1,4-Cyclohexylenrest, Isophoronylenrest und der 4,4'-Methylen-dicyclohexylenrest; Alkenylenreste, wie der Vinylen-, n-Hexenylen-, Cyclohexenylen-, 1-Propenylen-, Allylen-, Butenylen- und 4-Pentenylenrest; Alkinylenreste, wie der Ethinylen- und Propargylenrest; Arylenreste, wie der Phenylen-, Bisphenylen-, Naphthylen-, Anthrylen- und Phenanthrylenrest; Alkarylenreste, wie o-, m-, p-Toluylenreste, Xylylenreste und Ethylphenylenreste; und Aralkylenreste, wie der Benzylenrest, der 4,4'-Methylen-diphenylenrest, der α- und der β-Phenylethylenrest.

Vorzugsweise handelt es sich bei Rest Y um einen Kohlenwasserstoffrest mit 3 bis 13 Kohlenstoffatomen, besonders bevorzugt um Aralkylen-, lineare oder cyclische Alkylenreste.

Beispiele für Reste D sind die für Y angegebenen Beispiele, sowie Polyoxyalkylenreste, wie Polyoxyethylenreste oder Polyoxypropylenreste.

Vorzugsweise bedeutet D einen zweiwertigen, gegebenenfalls durch Fluoratome, Chloratome oder C₁-C₆-Alkylestergruppen substituierten Kohlenwasserstoffrest mit 1 bis 800 Kohlenstoffatomen oder einen Polyoxyalkylenrest. Im Fall von D gleich gegebenenfalls substituierten Kohlenwasserstoffrest handelt es sich bevorzugt um Alkylenreste mit mindestens 2 bis 12 Kohlenstoffatomen, insbesondere mit mindestens 4 bis 12 Kohlenstoffatomen. Im Fall von D gleich Polyoxyalkylenrest handelt es sich bevorzugt um solche mit 20 bis 800 Kohlenstoffatomen, besonders bevorzugt 100 bis 800 Kohlenstoffatomen, insbesondere 100 bis 200 Kohlenstoffatomen, wobei es sich ganz bevorzugt um Polyoxyethylenreste oder Polyoxypropylenreste handelt.

Index n bedeutet vorzugsweise eine Zahl von 3 bis 800, besonders bevorzugt 3 bis 400, insbesondere 25 bis 250.

Vorzugsweise bedeutet a eine Zahl von 1 bis 1000, besonders bevorzugt von höchstens 250, insbesondere höchstens 150.

Wenn b ungleich 0, bedeutet b vorzugsweise eine Zahl von höchstens 250, insbesondere höchstens 50.
c bedeutet vorzugsweise 0 oder eine Zahl von höchstens 10, insbesondere 0 oder eine Zahl von höchstens 5.

In der erfindungsgemäß eingesetzten Verbindung der Formel (1) können die a Organopolysiloxan-, b Polyharnstoff- und c Polyurethan-Blöcke beliebig, z.B. statistisch, verteilt sein.

Als Endgruppen der erfindungsgemäß eingesetzten Verbindung der Formel (1) können übliche Endgruppen nach dem Stand der Technik vorkommen, die bei der Synthese solcher Polymere standardmäßig entstehen, wie beispielsweise Amino- oder Isocyanat-Endgruppen. Diese können während der Synthese oder nachträglich noch mit weiteren Gruppen umgesetzt werden, wie beispielsweise mit Amino- oder Isocyanato-Silanen. Weiterhin ist es möglich, bereits während der Synthese monofunktionelle organische Verbindungen hinzuzugeben, welche gegenüber Isocyanatgruppen reaktiv sind, wie z.B. primäre oder sekundäre Alkohole oder Amine, womit sich auf elegante Art und Weise zusätzlich die rheologischen Eigenschaften und das Molekulargewicht der thermoplastischen Siloxancopolymere (B) steuern lassen. Die thermoplastischen Siloxancopolymere (B) enthalten daher vorzugsweise als Endgruppen einen funktionellen oder nicht-funktionellen organischen oder siliciumorganischen Rest.

Thermoplastische Siloxancopolymere, wie sie als Komponente (B) eingesetzt werden können, und Verfahren zu deren Herstellung sind beispielsweise in EP 1412416 B1 und EP 1489129 B1 beschrieben, deren diesbezügliche Offenbarung auch Gegenstand dieser Anmeldung sein soll.

Beispiele für thermoplastische Siloxancopolymere der Formel (1) sind solche, bei denen
R= CH₃-, X= -(CH₂)₃-, A= -NH-, n=35-45, b=0, c=0,
Y= -*p*-C₆H₄-CH₂-_{P}-C₆H₄- sowie a=40-70 bedeuten und die mit Wasserstoffatom am Rest A und dem Rest -NH(CH₂)₃₅iMe₂(OSiMe₂)₃₅₋₄₅(CH₂)₃-NH₂ am Carbonylkohlenstoffatom terminiert sind;
R= CH₃-, X= -(CH₂)₃-, A= -NH-, n=35-45, b=0, c=0, Y= -*p*-C₆H₄-CH₂-p-C₆H₄- sowie a=40-70 bedeuten und die mit Wasserstoffatom am Rest A und dem Rest -NH(CH₂)₃SiMe₂(OSiMe₂O)₃₅₋₄₅(CH₂)₃-NH-CO-NH-Y-NCO am Carbonylkohlenstoffatom terminiert sind;
R= CH₃-, X= -(CH₂)₃-, A= -NH-, n=35-45, b=0, c=0,
Y= 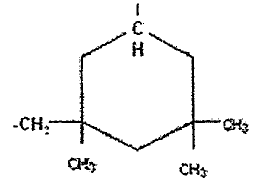 sowie a=25-35 bedeuten und die mit Wasserstoffatom am Rest A und dem Rest -NH(CH₂)₃SiMe₂(OSiMe₂)₃₅₋₄₅(CH₂)₃-NH₂ am Carbonylkohlenstoffatom terminiert sind;
R= CH₃-, X= -(CH₂)₃-, A= -NH-, n=35-45, b=0, c=0,
Y= 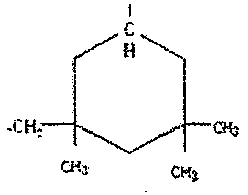 sowie a=25-35 bedeuten und die mit Wasserstoffatom am Rest A und dem Rest -NH(CH₂)₃SiMe₂(OSiMe₂O)₃₅₋₄₅(CH₂)₃-NH-CO-NH-Y-NCO am Carbonylkohlenstoffatom terminiert sind;
R= CH₃-, X= -(CH₂)₃-, A= -NH-, n=35-45, b=0, c=0,
Y= 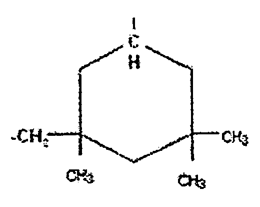 und a=60-70 bedeuten und die mit Wasserstoffatom am Rest A und dem Rest -NH(CH₂)3SiMe₂(OSiMe₂)₃₅₋₄₅(CH₂)₃-NH₂ am Carbonylkohlenstoffatom terminiert sind;
R= CH₃-, X= -(CH₂)₃-, A= -NH-, n=35-45, b=0, c=0,
Y= 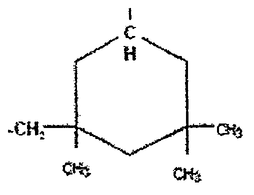 und a=60-70 bedeuten und die mit Wasserstoffatom am Rest A und dem Rest -NH(CH₂)₃SiMe₂(OSiMe₂O)₃₅₋₄₅(CH₂)₃-NH-CO-NH-Y-NCO am Carbonylkohlenstoffatom terminiert sind;
R= CH₃-, X= -(CH₂)₃-, A= -NH-, n=35-45, b=0, c=0,
   Y= -(CH₂)₆- sowie a= 25-35 bedeuten und die mit Wasserstoffatom am Rest A und dem Rest -NH(CH₂)₃SiMe₂(OSiMe₂)₃₅₋₄₅(CH₂)₃-NH₂ am Carbonylkohlenstoffatom terminiert sind;
R= CH₃-, X= -(CH₂)₃-, A= -NH-, n=35-45, b=0, c=0,
   Y= -(CH₂)₆- sowie a= 25-35 bedeuten und die mit Wasserstoffatom am Rest A und dem Rest -NH(CH₂)₃SiMe₂(OSiMe₂O)₃₅₋₄₅(CH₂)₃-NH-CO-NH-Y-NCO am Carbonylkohlenstoffatom terminiert sind;
R= CH₃-, X= -(CH₂)₃-, A= -NH-, n=35-45, b=0, c=0,
   Y= -(CH₂)₆- sowie a= 50-70 bedeuten und die mit Wasserstoffatom am Rest A und dem Rest -NH(CH₂)₃SiMe₂(OSiMe₂)₃₅₋₄₅(CH₂)₃-NH₂ am Carbonylkohlenstoffatom terminiert sind;
R= CH₃-, X= -(CH₂)₃-, A= -NH-, n=35-45, b=0, c=0,
   Y= -(CH₂)₆- sowie a= 50-70 bedeuten und die mit Wasserstoffatom am Rest A und dem Rest -NH(CH₂)₃SiMe₂(OSiMe₂O)₃₅₋₄₅(CH₂)₃-NH-CO-NH-Y-NCO am Carbonylkohlenstoffatom terminiert sind;
R= CH₃-, X= -(CH₂)₃-, A= -NH-, n=35-45, b=0, c=0,
   Y= -C(CH₃)₂-*m*-C₆H₄-C(CH₃)₂- sowie a= 25-35 bedeuten und die mit Wasserstoffatom am Rest A und dem Rest -NH(CH₂)₃SiMe₂(OSiMe₂)₃₅-₄₅(CH₂)₃-NH₂ am Carbonylkohlenstoffatom terminiert sind;
R= CH₃-, X= -(CH₂)₃-, A= -NH-, n=35-45, b=0, c=0,
   Y= -C(CH₃)₂-*m*-C₆H₄-C(CH₃)₂- sowie a= 25-35 bedeuten und die mit Wasserstoffatom am Rest A und dem Rest -NH(CH₂)₃SiMe₂(OSiMe₂O)₃₅-₄₅(CH₂)₃-NH-CO-NH-Y-NCO am Carbonylkohlenstoffatom terminiert sind;
R= CH₃-, X= -(CH₂)₃-, A= -NH-, n=35-45, b=0, c=0,
   Y= -C(CH₃)₂-*m*-C₆H₄-C(CH₃)₂- sowie a= 50-70 bedeuten und die mit Wasserstoffatom am Rest A und dem Rest -NH(CH₂)₃SiMe₂(OSiMe₂)₃₅-₄₅(CH₂)₃-NH₂ am Carbonylkohlenstoffatom terminiert sind;
R= CH₃-, X= -(CH₂)₃-, A= -NH-, n=35-45, b=0, c=0,
   Y= -C(CH₃)₂-*m*-C₆H₄-C(CH₃)₂- sowie a= 50-70 bedeuten und die mit Wasserstoffatom am Rest A und dem Rest -NH(CH₂)₃SiMe₂(OSiMe₂O)₃₅-₄₅(CH₂)₃-NH-CO-NH-Y-NCO am Carbonylkohlenstoffatom terminiert sind;
R= CH₃-, X= -(CH₂)₃-, A= -NH-, n=35-45, b=0, c=0,
   Y= -*p*-C₆H₁₀-CH₂-*p*-C₆H₁₀- sowie a= 25-35 bedeuten und die mit Wasserstoffatom am Rest A und dem Rest -NH(CH₂)₃SiMe₂(OSiMe₂)₃₅-₄₅(CH₂)₃-NH₂ am Carbonylkohlenstoffatom terminiert sind;
R= CH₃-, X= -(CH₂)₃-, A= -NH-, n=35-45, b=0, c=0,
   Y= -*p*-C₆H₁₀-CH₂-*p*-C₆H₁₀- sowie a= 25-35 bedeuten und die mit Wasserstoffatom am Rest A und dem Rest -NH(CH₂)₃SiMe₂(OSiMe₂O)₃₅-₄₅(CH₂)₃-NH-CO-NH-Y-NCO am Carbonylkohlenstoffatom terminiert sind;
R= CH₃-, X= -(CH₂)₃-, A= -NH-, n=35-45, b=0, c=0,
   Y= -*p*-C₆H₁₀-CH₂-*p*-C₆H₁₀- sowie a= 50-70 bedeuten und die mit Wasserstoffatom am Rest A und dem Rest -NH(CH₂)₃SiMe₂(OSiMe₂)₃₅-₄₅(CH₂)₃-NH₂ am Carbonylkohlenstoffatom terminiert sind;
R= CH₃-, X= -(CH₂)₃-, A= -NH-, n=35-45, b=0, c=0,
   Y= -*p*-C₆H₁₀-CH₂-*p*-C₆H₁₀- sowie a= 50-70 bedeuten und die mit Wasserstoffatom am Rest A und dem Rest -NH(CH₂)₃SiMe₂(OSiMe₂O)₃₅-₄₅(CH₂)₃-NH-CO-NH-Y-NCO am Carbonylkohlenstoffatom terminiert sind;
R= CH₃-, X= -(CH₂)₃-, A= -NH-, n=140-155, b=0, c=0,
   Y= -C(CH₃)₂-*m*-C₆H₄-C(CH₃)₂- sowie a= 50-70 bedeuten und die mit Wasserstoffatom am Rest A und dem Rest -NH(CH₂)₃SiMe₂(OSiMe₂)₁₄₀-₁₅₅(CH₂)₃-NH₂ am Carbonylkohlenstoffatom terminiert sind;
R= CH₃-, X= -(CH₂)₃-, A= -NH-, n=140-155, b=0, c=0,
   Y= -C(CH₃)₂-*m*-C₆H₄-C(CH₃)₂- sowie a= 50-70 bedeuten und die mit Wasserstoffatom am Rest A und dem Rest -NH(CH₂)₃SiMe₂(OSiMe₂)₁₄₀-₁₅₅(CH₂)₃-NH-CO-NH-Y-NCO am Carbonylkohlenstoffatom terminiert sind;
R= CH₃-, X= -(CH₂)₃-, A= -NH-, n=140-155, b=0, c=0,
   Y= -C(CH₃)₂-*m*-C₆H₄-C(CH₃)₂- sowie a= 20-35 bedeuten und die mit Wasserstoffatom am Rest A und dem Rest -NH(CH₂)₃SiMe₂(OSiMe₂)₁₄₀-₁₅₅(CH₂)₃-NH₂ am Carbonylkohlenstoffatom terminiert sind;
R= CH₃-, X= -(CH₂)₃-, A= -NH-, n=140-155, b=0, c=0,
   Y= -C(CH₃)₂-*m*-C₆H₄-C(CH₃)₂- sowie a= 20-35 bedeuten und die mit Wasserstoffatom am Rest A und dem Rest -NH(CH₂)₃SiMe₂(OSiMe₂)₁₄₀-₁₅₅(CH₂)₃-NH-CO-NH-Y-NCO am Carbonylkohlenstoffatom terminiert sind;
R= CH₃-, X= -(CH₂)₃-, A= -NH-, n=35-45, Y= -(CH₂)₆-, a= 15-25, b= 15-25 sowie c=0 bedeuten und die mit Wasserstoffatom am Rest A und dem Rest -NH(CH₂)₃SiMe₂(OSiMe₂)₃₅₋₄₅(CH₂)₃-NH₂ am Carbonylkohlenstoffatom terminiert sind;
R= CH₃-, X= -(CH₂)₃-, A= -NH-, n=35-45, Y= -(CH₂)₆-, a= 15-25, b= 15-25 sowie c=0 bedeuten und die mit Wasserstoffatom am Rest A und dem Rest -NH(CH₂)₃SiMe₂(OSiMe₂O)₃₅-₄₅(CH₂)₃-NH-CO-NH-Y-NCO am Carbonylkohlenstoffatom terminiert sind;
R= CH₃-, X= -(CH₂)₃-, A= -NH-, n=35-45,
Y= 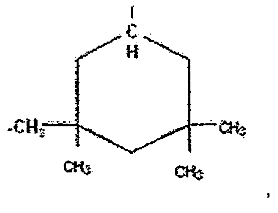 a= 15-25, b= 15-25 sowie c=0 bedeuten und die mit Wasserstoffatom am Rest A und dem Rest -NH(CH₂)₃SiMe₂-(OSiMe₂)₃₅₋₄₅(CH₂)₃-NH₂ am Carbonylkohlenstoffatom terminiert sind, und
R= CH₃-, X= -(CH₂)₃-, A= -NH-, n=35-45,
Y= 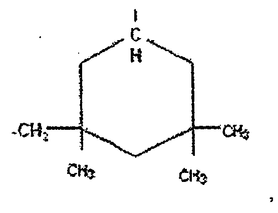 a= 15-25, b= 15-25 sowie c=0 bedeuten und die mit Wasserstoffatom am Rest A und dem Rest -NH(CH₂)₃SiMe₂-(OSiMe₂O)₃₅₋₄₅(CH₂)₃-NH-CO-NH-Y-NCO am Carbonylkohlenstoffatom terminiert sind.

Durch das Zusammenspiel von Siloxangehalt, Kettenlänge des verwendeten Siloxanpolymers und Gehalt an Urethan- bzw. Harnstoffgruppen lässt sich der Erweichungspunkt der thermoplastischen Siloxancopolymere der Formel (1) zielgenau einstellen. Das erfindungsgemäß eingesetzte thermoplastische Siloxancopolymer der Schicht (B) hat bei dem Druck der umgebenden Atmosphäre, also zwischen 900 und 1100 hPa, einen Erweichungspunkt von bevorzugt mindestens 40°C, besonders bevorzugt aber solche im Bereich von 100 bis 180°C.

Vorzugsweise besitzen die thermoplastischen Siloxancopolymere der allgemeinen Formel (1) einen Siloxangehalt von 50 bis 99,9 Gew.%, bevorzugt 80 bis 98 Gew.%, insbesondere von 90 bis 95 Gew.%.

Das gewichtsmittlere Molekulargewicht M_{w} der thermoplastischen Siloxancopolymere der Formel (1) beträgt bevorzugt 10 000 bis 10·10⁶ g/mol, besonders bevorzugt 30 000 bis 10⁶ g/mol, insbesondere 50 000 bis 500 000 g/mol.

Um eine hohe Langzeitbeständigkeit des erfindungsgemäßen Klebeverbundes zu gewährleisten, muss Schicht (B) die Kräfte, die durch die unterschiedlichen Wärmeausdehungskoeffizienten von beispielsweise Fensterglas (7,5*10⁻⁶ K⁻¹), insbesondere aber technischen Kunststoffen (50 bis 150*10⁻⁶ K⁻¹), gegenüber z.B. Silizium (2*10⁻⁶ K⁻¹) während der Erwärmungs- und Abkühlzyklen im Betrieb eines Solarmoduls auftreten, kompensieren. Hierzu sind einerseits gute mechanische Eigenschaften erforderlich. Andererseits darf Schicht (B) nicht zu weich sein, sondern muss eine gewisse Härte und Steifigkeit, welche beispielsweise durch den E-Modul charakterisierbar ist, aufweisen. Schichten (B) mit einem zu hohen E-Modul sind jedoch ebenfalls zu vermeiden, da diese dann zu hart sind und die zerbrechlichen Solarzellen-einheiten bei Wärmeausdehnung zerreißen. Für Schicht (B) ist somit ein ausgewogener Kompromiss zwischen mechanischer Beständigkeit, Härte und E-Modul zu finden, wie es beispielsweise durch die Verwendung der thermoplastischen Siloxancoplymere der Formel (1) möglich ist.

Die Härte der erfindungsgemäß eingesetzten thermoplastischen Siloxancopolymere (B) bewegt sich daher vorzugsweise im mittleren Bereich der Shore-A-Skala, d.h. bevorzugt sind Copolymere mit einer Härte gemäß DIN 53505 von 20 bis 80 ShA, insbesondere von 30 bis 60 ShA.

Der E-Modul der erfindungsgemäß eingesetzten thermoplastischen Copolymere bei 100 % Dehnung beläuft sich nach DIN 53504 S2 bei Raumtemperatur vorzugsweise auf Werte von bis zu 3 N/mm², bevorzugt 0,5 bis 2,5 N/mm².

Die Reißfestigkeit der erfindungsgemäß eingesetzten thermoplastischen Copolymere beträgt nach DIN 53504 S2 vorzugsweise mindestens 1,5 N/mm², bevorzugt mindestens 3 N/mm², insbesondere mindestens 4,5 N/mm².

Die Weiterreißfestigkeit der erfindungsgemäß eingesetzten thermoplastischen Copolymere beträgt nach ASTM 624 B vorzugsweise mindestens 10 N/mm, bevorzugt jedoch mindestens 20 N/mm.

Die erfindungsgemäß eingesetzten thermoplastischen Siloxancopolymere besitzen typischerweise einen Brechungsindex zwischen 1,4 und 1,45. Durch Einführen von Phenylresten in den Siloxanteil des Copolymers können jedoch auch Brechungsindices von bis zu 1,5 erreicht werden.

Der Wärmeausdehnungskoeffizient der thermoplastischen Siloxanpolymere beträgt bei Raumtemperatur bevorzugt 100·10⁻⁶ bis 750·10⁻⁶ K⁻¹, besonders bevorzugt 250·10⁻⁶ bis 500·10⁻⁶K⁻¹.

Die Schicht (B) kann aus einem einheitlichen Material bestehen oder auch selbst mehrschichtig aus verschiedenen Schichten des thermoplastischen Siloxancopolymers aufgebaut sein oder ein Laminat aus verschiedenartigen Polymeren sein, von der mindestens eine aus dem thermoplastischen Siloxancopolymer bestehen muss.

Die erfindungsgemäß eingesetzten Einheiten (C) enthalten eine oder mehrere Schichten eines photosensitiven Halbleiters, der in amorpher, mono-, mikro- oder polykristalliner Form sowie in Kombinationen hiervon vorliegen kann. Geeignete Halbleiterschichten sind beispielsweise solche, die auf amorphem, mono-, mikro- oder polykristallinem Silizium, Gallium-Arsenid, Kupfer-Indium-Disulfid, Kupfer-Indium-Diselenid, Kupfer-Indium-Gallium-Diselenid, Cadmium-Tellurid oder anderen hableitenden Elementen und Elementkombinationen aufbauen. Einheiten (C) der beschriebenen Art sind allgemein bekannt und beispielsweise in Ullmanns's Encyclopedia Of Industrial Chemistry, 5. Auflage, 1992, Vol. A20, Seite 164-175 beschrieben.

Zur Optimierung der Lichtausbeute können die Halbleiterschichten zusätzlich mit einer speziellen Oberflächenstruktur oder einer Antireflexschicht (sog. AR-Coating, Antireflective Coating) auf Basis von z.B. Titandioxid, Siliziumdioxid, Silizium-Nitriden oder ähnlichem versehen sein, wodurch etwaige Ausbeuteverluste durch Reflexion vermindert werden. Die Herstellung texturierter Oberflächen von Halbleiterschichten ist beispielhaft in DE 10352423 B3 beschrieben. DE 19919742 A1 legt Methoden zur Erzeugung von Antireflexschichten offen. Im Sinne der vorliegenden Erfindung sind beide Methoden zur Modifizierung der Halbleiterschichten gleichermaßen bevorzugt.

Die Einheit (C) kann sowohl als eigenständige Struktur als auch in geträgerter Form auf einem Trägermaterial, beispielsweise Glas oder Folien aus organischen Polymeren, vorliegen.

Die Einheit (C) kann nach bekannten Verfahren in geeigneter Weise über Kontaktierungsbahnen zu einer oder mehreren photovoltaischen Zellen verschaltet werden, wobei der Begriff photovoltaische Zelle im Sinne der vorliegenden Erfindung alle Baugruppen umfassen soll, welche unter Ausnutzung des photovoltaischen Effekts dazu in der Lage sind, Licht in elektrischen Strom umzuwandeln. Darüber hinaus ist es möglich, mehrere photovoltaische Zellen zu Gruppen (sog. Solarzellenstrings) miteinander zu verbinden, was nach einer beliebigen Methode des Stands der Technik, beispielsweise durch Verlöten, Verpressen oder Verkleben mit Hilfe von leitfähigen Klebstoffen, erfolgen kann.

Das erfindungsgemäße Laminat kann gegebenenfalls weitere Schichten (D) enthalten, die bevorzugt ausgewählt sind aus der Gruppe bestehend aus metallischen Werkstoffen, mineralischen Werkstoffen, organischen und siliciumorganischen Polymeren, wie Polyvinylbutyral, Polyurethane, Polyharnstoffe, Polyvinylchlorid, Epoxide, Polyester, (Meth)-Acrylate, Polyethylen, Polyvinylacetat, Polypropylen, PVC, Polystyrol, Polycarbonat, Polymere fluorierter organischer Kohlenwasserstoffe, Silicone, Siliconharzpolymere, modifizierte Siliconpolymere, Heißschmelz-Klebstoffe, Beschichtungen, Dichtungsmassen und Plastisole, sowie deren Mischungen, Copolymere und Laminate, wobei das Material der Schicht (D) von denen der Schichten (A), (B) und (C) verschieden ist.

Geeignete organische Polymere sind beispielsweise Polyvinylfluorid (PVF) oder dessen Colaminate mit Polyethylenterephthalat (PET) (wie z.B. solche, die unter dem Markennamen TEDLAR^{®} der Fa. DuPont erhältlich sind). Geeignete Silicone sind beispielsweise UV- oder heißvernetzende Silicone, kaltvernetzende 2-K-Silicone und feuchtigkeitsvernetzende Silicone mit einem Transmissionsgrad _{D65} (gemäß DIN 5036, Teil 3) von kleiner 80 %. Geeignete metallische Werkstoffe sind beispielsweise Aluminiumplatten und -folien oder deren Colaminate, wie z.B PVF/Aluminium/PVF- oder PVF/Aluminium/PET-Verbundfolien.

Besonders bevorzugt handelt es sich bei den gegebenenfalls vorhandenen weiteren Schichten (D) um organische Polymere und deren Laminate untereinander sowie deren Laminate mit metallischen Werkstoffen.

Das erfindungsgemäße Laminat weist bevorzugt mindestens eine Schicht (D) auf.

Das erfindungsgemäße Laminat ist sandwichartig aufgebaut und kann von einer jeden der Schichten (A), (B), (C) und gegebenenfalls (D) jeweils eine oder mehrere Schichten aufweisen. Beispielsweise kann das Laminat zusätzlich weitere Schichten (B) enthalten, um z.B. Schicht (C) mit einer zusätzlich vorhandenen Schicht (D) oder einer zweiten Schicht (A) zu verbinden.

In einer bevorzugten Ausführungsform enthält das erfindungsgemäße Laminat eine Schicht (A) aus anorganischem Glas, eine Schicht (B) des thermoplastischen Siloxancopolymers und eine Einheit (C) enthaltend mindestens eine photosensitive Schicht.

In einer weiteren bevorzugten Ausführungsform enthält das erfindungsgemäße Laminat eine Schicht (A) aus organischem Glas, eine Schicht (B) des thermoplastischen Siloxancopolymers sowie eine Schicht (C) bestehend aus mindestens einer photosensitiven Halbleiterschicht.

In einer besonders bevorzugten Ausführungsform enthält das erfindungsgemäße Laminat mindestens eine weitere zusätzliche Schicht aus anorganischem oder organischem Glas (A) oder metallischen Werkstoffen oder organischen Polymeren und Copolymeren (D). Falls Schicht (D) im erfindungsgemäßen Laminat vorhanden ist, so liegt diese vorzugsweise in Folienform vor, wobei es sich bei Schicht (D) besonders bevorzugt um eine Verbundfolie handelt.

Die Schicht (A) zeigt Schichtdicken von bevorzugt mehr als 1 µm. Besonders bevorzugt werden Schichtdicken von 10 µm bis 20 mm.

Die Schicht (B) zeigt Schichtdicken von bevorzugt mehr als 1 µm, wobei eine Schichtdicke von 10 µm bis 3 mm besonders bevorzugt ist. Insbesondere beträgt die Schichtdicke 10 µm bis 1 mm.

Die Schicht (C) zeigt Schichtdicken von bevorzugt mehr als 1 µm, wobei eine Schichtdicke von 5 µm bis 10 mm besonders bevorzugt ist. Insbesondere beträgt die Schichtdicke 10 µm bis 2 mm.

Die gegebenenfalls vorhandenen weiteren Schichten (D) zeigen Schichtdicken von bevorzugt mehr als 1 µm, wobei jeweils eine Schichtdicke von 10 µm bis 20 mm besonders bevorzugt ist.

Die erfindungsgemäßen Laminate haben eine Dicke von bevorzugt 12 µm bis 100 mm, besonders bevorzugt 20 µm bis 50 mm, insbesondere von 20 µm bis 30 mm.

Die erfindungsgemäßen Laminate zeigen gute optische Qualität, bedingt durch die gute Haftung von (B) an (A) bzw. (B) an (C), als auch durch die hervorragenden Eigenschaften von (B), insbesondere hinsichtlich Wasser.

Zur Verbesserung der Haftung können dem thermoplastischen Siloxancopolymer der Schicht (B) haftvermittelnde Silane zugegeben werden, wie beispielsweise Silane mit hydrolysierbaren Gruppen und SiC-gebundenen Vinyl-, Acryloxy-, Methacryloxy-, Isocyanato-, Epoxy-, Säureanhydrid-, Säure-, Ester- oder Ethergruppen sowie deren Teil- und Mischhydrolysate.

Beispiele für gegebenenfalls eingesetzte Haftvermittler sind 3-Isocyanatopropyltrimethoxysilan, 3-Isocyanatopropyltriethoxysilan, 3-Isocyanatopropyldimethoxymethylsilan, 3-Isocyanatopropyldiethoxymethylsilan, 3-Isocyanatopropylmethoxydimethylsilan, 3-Isocyanatopropylethoxydimethylsilan, Isocyanatomethyltrimethoxysilan, Isocyanatomethyltriethoxysilan, Isocyanatomethyldimethoxymethylsilan, Isocyanatomethyldiethoxymethylsilan, Isocyanatomethylmethoxydimethylsilan und Isocyanatomethylethoxydimethylsilan, 3-Aminopropyltrimethoxysilan, 3-Aminopropyltriethoxysilan, 3-(2-Aminoethyl)aminopropyltrimethoxysilan, 3-(2-Aminoethyl)aminopropyltriethoxysilan, 3-Aminopropylmethyldimethoxysilan, 3-(2-Aminoethyl)aminopropylmethyldimethoxysilan, Cyclohexylaminomethyltriethoxysilan, Glycidoxypropyltrimethoxysilan und Glycidoxypropyltriethoxysilan.

Falls Haftvermittler in Komponente (B) eingesetzt wird, sind Silane mit Vinylgruppen und Silane mit Epoxygruppen, die als hydrolysierbare Reste Ethoxy- oder Acetoxygruppen enthalten, bevorzugt, wobei Glycidoxypropyltriethoxysilan, Vinyltriethoxysilan und Vinyltriacetoxysilan und/oder deren Teil- und Mischhydrolysate besonders bevorzugt sind.

Falls Haftvermittler eingesetzt wird, handelt es sich um Mengen von bevorzugt 0,01 bis 5 Gew.-%, besonders bevorzugt 0,1 bis 2 Gew.-%, insbesondere 0,4 und 0,7 Gew.-%, jeweils bezogen auf die Gesamtmasse an Komponente (B).

Der gegebenenfalls eingesetzte Haftvermittler kann mit dem thermoplastischen Siliconcopolymer einfach vermischt werden.

Die haftvermittelnden Silane, deren Hydrolyse- oder Kondensationsprodukte bzw. deren Lösungen in organischen Lösungsmitteln, können auch auf die Oberfläche der aus den thermoplastischen Siloxancopolymeren hergestellten Folien aufgebracht werden.

Vorzugsweise können haftvermittelnde Silane auf die Folie aus thermoplastischem Siloxancopolymer, auf die Schicht (A), auf die Schicht (C) und/oder auf die gegebenenfalls eingesetzte weitere Schicht (D) aufgebracht werden. Das Aufbringen der haftvermittelnden Silane erfolgt nach bekannten Verfahren vor der Herstellung des Verbundes. Für dieses Verfahren hat sich der Be-griff "Primern" oder "Grundieren" eingebürgert.

Dem thermoplastischen Siloxancopolymer können darüber hinaus weitere Additive zugegeben werden, sofern sie die optischen Eigenschaften nicht negativ verändern. Beipiele für geeignete Additive sind Farbstoffe, Pigmente, Füllstoffe, Katalysatoren, Hitzestabilisatoren, Weichmacher, Vernetzer, Flammschutzmittel und Lichtstabilisatoren oder deren Mischungen. Solche Additive sind dem Fachmann aus der Polyurethan- und Siliconchemie bekannt und können mit dem Siloxancopolymer einfach vermischt werden.

Ebenso können die organischen Polymere der Schicht (D) sowie die organischen Gläser der Schicht (A) Additive enthalten. Alle diese Additive können materialspezifisch sein und sind dem Fachmann bekannt.

Die Herstellung des erfindungsgemäßen Verbundes zwischen den Schichten (A), (B) und (C) bzw. gegebenenfalls zwischen den Schichten (C), (B) und (D) kann nach an sich bekannten Verfahren erfolgen.

Zur Herstellung des erfindungsgemäßen Laminats gibt es prinzipiell mehrere Möglichkeiten. Eine Möglichkeit besteht darin, dass auf Schicht (A) verflüssigtes thermoplastisches Siloxancopolymer durch beispielsweise Rakeln, Walzen oder auch Siebdruck aufgebracht wird, wodurch nach Abkühlung gewissermaßen in-situ Schicht (B) hergestellt wird. Das erfindungsgemäße Laminat wird anschließend dadurch erzeugt, dass die Schicht (C) auf die noch flüssige Schicht (B) gelegt und zu einem Verbund verpresst wird. Ebenso ist es selbstverständlich möglich, die verflüssigte Schicht (B) wie zuvor beschrieben zunächst auf Schicht (C) aufzutragen, danach Schicht (A) auf die Schicht (B) zu legen und anschließend alle Schichten durch Verpressen zu einem Laminat zu verbinden.

Die zweite Möglichkeit besteht darin, dass auf Schicht (A) das mit Lösemittel verflüssigte thermoplastische Siloxancopolymer (B) durch beispielsweise Rakeln, Walzen oder auch Siebdruck aufgebracht und danach das Lösemittel abgedampft wird. Auf die so erhaltene Doppelschicht aus Schicht (A) und (B) wird anschließend Schicht (C) aufgelegt. Das erfindungsgemäße Laminat wird nun durch Temperaturerhöhung bis zum Erweichen des thermoplastischen Siloxancopolymers der Schicht (B) und gleichzeitigem Pressen des Verbundes erhalten. Selbstverständlich ist es auch bei dieser Vorgehensweise möglich, das mit Lösemittel verflüssigte thermoplastische Siloxancopolymer der Schicht (B) zunächst auf Schicht (C) aufzutragen, danach Schicht (A) auf Schicht (B) zu legen und anschließend alle Schichten durch Verpressen zu einem Laminat zu verbinden.

Eine dritte Möglichkeit besteht darin, dass die beiden Schichten (A) und (C) durch geeignete Abstandshalter so zusammengesetzt werden, dass ein Spalt von definierter Breite erhalten wird. In diesen Spalt wird nun verflüssigtes thermoplastisches Siloxancopolymer der Schicht (B) aus einem geeigneten beheizten Vorratsgefäß durch eine Dosiereinrichtung eingebracht, wobei die Kanten der Schichten (A) und (C) so verschlossen sind, dass die Polymerschmelze nicht an unerwünschten Stellen austritt und nur die zwischen den Schichten (A) und (C) befindliche Luft entweichen kann.

Die bevorzugte, vierte Möglichkeit der Herstellung des Laminatglases besteht darin, Schicht (B) enthaltend thermoplastisches Siloxancopolymer als Folie herzustellen. Bevorzugt wird eine geprägte Folie mit einer definierten Oberflächenrauigkeit (Textur) eingesetzt, um Lufteinschlüsse beim Laminieren zu minimieren. Der Verbund wird anschließend erhalten, indem die Folienschicht (B) zwischen die Schichten (A) und (C) gelegt wird und die Schichten (A) bis (C) unter Druck und Temperatur dauerhaft miteinander verbunden werden.

Falls eine oder mehrere Schichten, wie etwa Schicht (D), vorliegen, kann die Herstellung des Laminatverbundes, z.B. zwischen den Schichten (C) und (D) mittels Schicht (B), in der gleichen Weise erfolgen, wie zuvor für den Laminatverbund zwischen den Schichten (A) und (C) beschrieben. Selbstverständlich kann in allen der oben beschriebenen Fällen eine Vorbehandlung der Schichten (A), (B), (C) und/oder (D) mit Haftvermittlern erfolgen.

Die erfindungsgemäße Laminatherstellung kann entweder durch schrittweisen Schichtaufbau, d.h. zunächst Aufbau einer oder mehrerer Verbundschichten, z.B. aus Schicht (A) und Schicht (B) bzw. gegebenenfalls Schicht (B) und Schicht (D), und anschließendes Laminieren der Verbundschichten mit Schicht (C) oder in einem einzigen Laminierschritt erfolgen.

Die erfindungsgemäßen Laminate können sowohl mit Hilfe von diskontinuierlichen Laminatoren, wie sie bisher in der Fertigung von Solarmodulen Anwendung finden, als auch mit Hilfe von Rollenlaminatoren hergestellt werden. Letztere bieten den Vorteil eines kontinuierlichen Betriebs und - falls die Gläser der Schicht (A) und gegebenenfalls Schicht (D) in Folienform vorliegen - die Herstellung theoretisch endloser Laminate.

Das bevorzugte Verfahren zur Herstellung der erfindungsgemäßen Laminate ist **dadurch gekennzeichnet, dass**
in einem 1. Schritt Schicht (B) aus einem thermoplastischen Siloxancopolymer sowie gegebenenfalls weiteren Zusätzen in Form einer Folie mit einer Dicke von bevorzugt 0,1 bis 3 mm hergestellt wird,
in einem 2. Schritt die im 1. Schritt erhaltene Folienschicht (5) zwischen die zu laminierenden Schichten (A) und (C) sowie gegebenenfalls (C) und (D) gebracht wird und
in einem 3. Schritt die einzelnen Schichten bei einer Temperatur, die bevorzugt 10 bis 50°C über der Erweichungstemperatur des verwendeten thermoplastischen Siloxancopolymers liegt, und einem Druck, der bevorzugt zwischen dem Druck der umgebenden Atmosphäre, also ca. 1000 hPa, und 20 000 hPa liegt, zu einem Laminat verbunden werden.

Vorzugsweise besitzt die im 1. Schritt hergestellte Folie des thermoplastischen Siloxancopolymers eine für Laminatfolien typische Oberflächentextur, wobei die Texturierung der Folienoberfläche bei Folienherstellung und nach dem Stand der Technik erfolgt.

Besonders bevorzugt liegt die Laminiertemperatur im 3. Schritt des erfindungsgemäßen Verfahrens 20 bis 40°C über der Erweichungstemperatur des verwendeten thermoplastischen Siloxancopolymers, bevorzugt also bei 60 bis 250°C, besonders bevorzugt bei 100 bis 200°C, insbesondere bevorzugt bei 120 bis 180°C.

Vorzugsweise liegt der Laminierdruck im 3. Schritt bei höchstens 10 000 hPa.

Die Dauer des erfindungsgemäßen Verfahrens liegt bevorzugt zwischen 5 Sekunden und 60 Minuten, besonders bevorzugt zwischen 15 Sekunden und 30 Minuten, insbesondere zwischen 1 und 20 Minuten.

Die Herstellung der thermoplastische Siloxancopolymere enthaltenden Folien orientiert sich grundsätzlich an bekannten Verfahren. Beispiele für geeignete Folienherstellverfahren sind die Folienblasextrusion, die Chill-Roll-Extrusion, das Castingverfahren oder das Coextrusionsverfahren, wie sie z.B. in U11-manns's Encyclopedia Of Industrial Chemistry, 5. Auflage, 1988, Vol. A11, Seite 87-93 beschrieben sind.

Die erfindungsgemäßen Laminate werden bevorzugt zur Herstellung photovoltaischer Solarmodule verwendet, wobei diese dann noch zusätzliche Baukomponenten, wie z.B. Verkabelungen, Rahmenteile, Modul-Halterungen, elektrische und elektronische Bauteile, enthalten können.

In einer besonderen Ausführungsform besitzen die erfindungsgemäßen Laminate schalldämmende sowie zu Verbundsicherheitsverglasungen ähnliche Eigenschaften, so dass sie als Fassadenbauteil, Dachfläche, Wintergartenabdeckung, Schallschutzwand, Balkon- oder Brüstungselement, als Bestandteil von Fensterflächen oder als gestalterisches Element in der Architektur umbauter Flächen und Räume verwendet werden können.

Die erfindungsgemäßen Laminate besitzen eine Reihe von Vorteilen. Zum einen weist die Copolymerschicht (B) eine sehr hohe Transparenz über einen weiten Spektralbereich, insbesondere in den für z.B. auf Silizium-basierenden Solarzellen relevanten Arbeitsbereichen, auf, was eine hohe Solarenergieausbeute bedingt. Die Copolymerschicht (B) ist, wie alle Silicon-basierenden Systeme, Langzeit-UV-stabil. Komponente (B) enthaltende Folien müssen daher vorteilhafterweise, im Gegensatz zu beispielsweise den Folien aus EVA und PVB, keine UV-Stabilisatoren, die dann zu nachteiligen Effekten wie Vergilbung oder Eintrübung führen könnten, zugesetzt werden. Weiterhin ist die Polymerschicht (B) - anders als PVB - hochhydrophob und weist eine gezielt einstellbare, exzellente Haftung zu allen relevanten Substraten, wie z.B. Glas, technischen Kunststoffen und den Solarzelleneinheiten, auf. Delaminierungseffekte treten daher ebenfalls bei den üblicherweise beim Betrieb eines Solarmoduls herrschenden Temperaturen im allgemeinen nicht auf.

Die erfindungsgemäßen Laminate mit Coplymerschicht (B) haben daneben gegenüber Laminaten mit Einbettmaterialien nach dem Stand der Technik auch prozesstechnische Vorteile. Zum einen ist die Verarbeitung von Folien enthaltend thermoplastische Siliconcopolymere einfach in der Durchführung und ähnlich zur Herstellung von Verbundsicherheitsglas. Im Gegensatz zu organischen Gießharzen oder EVA sind auch keine weiteren Prozesshilfsmittel, wie Katalysatoren oder Venetzungsmittel, erforderlich, die den Prozess aufwändig und das Laminat anfällig für Folgeschäden machen können. Im Unterschied zur Herstellung von EVA enthaltenden Laminaten sind auch keine speziellen Vakuumlaminierapparaturen nötigt. Die Verklebung mit dem thermoplastischen Blockcopolymer (B) ist zudem reversibel; etwaige Laminierfehler können somit sofort nach Laminatherstellung auf einfache Weise korrigiert werden.

Ein weiterer Vorteil der erfindungsgemäßen Laminate ist ihre leichte Rezyklierbarkeit. Während die kostenintensiven Solarzelleneinheiten aus Laminaten mit nachvernetztem EVA, vernetzten Siliconen oder nicht mehr schmelzbaren organischen Gießharzen nur umständlich über pyrolytische Mehrstufenprozesse wiedergewonnen werden können und dabei zudem aufwändige Reinigungsprozesse durchlaufen müssen, können die erfindungsgemäßen Laminate durch einfaches Aufschmelzen der Copolymerschicht (B) bei erhöhter Temperatur delaminiert werden. Die so wiedergewonnenen Solarzelleneinheiten müssen anschließend nur noch mit Alkohol, wie z.B. Isopropanol, von etwaig anhaftendem Copolymer (B) gereinigt werden und können dann dem Wertstoffkreislauf wieder direkt zugeführt werden. Die erfindungesgemäßen Laminate sind demnach nicht nur in ihrer Herstellung, sondern auch in ihrer Wiederverwertung nachhaltig umweltverträglich und ressourcenschonend.

Das vollständig reversible Schmelzverhalten der Copolymere (B) eröffnet einen weiteren Vorteil der erfindungsgemäßen Laminate. Im Gegensatz zu Solarmodulen mit EVA, organischen Gießharzen oder vernetzten Siliconen als Klebeschicht können Blockcopolymere (B) enthaltende Solarmodule auf einfache Art und Weise durch Aufschmelzen, Delaminieren und erneutes Laminieren vor Ort repariert werden, z-B. bei Ausfall einer einzelnen Solarmoduleinheit. Eine solche in-field-Reparatur kann beispielsweise vom Solaranlagenbauer selbst durchgeführt werden; Korrekturmaßnahmen durch den Solarmodulhersteller sind nur noch in Ausnahmefällen nötig.

Des Weiteren haben die erfindungsgemäßen Laminate den Vorteil, dass sie eine hohe Flexibilität bis weit unter 0°C aufweisen.

In den nachfolgenden Beispielen beziehen sich alle Angaben von Teilen und Prozentsätzen, soweit nicht anders angegeben, auf das Gewicht. Sofern nicht anders angegeben, werden die folgenden Beispiele bei einem Druck der umgebenden Atmosphäre, also bei etwa 1000 hPa, und bei Raumtemperatur, also etwa 20°C bzw. einer Temperatur, die sich beim Zusammengeben der Reaktanden bei Raumtemperatur ohne zusätzliche Heizung oder Kühlung einstellt, durchgeführt. Alle in den Beispielen angeführten Viskositätsangaben sollen sich auf eine Temperatur von 25°C beziehen.

Der Weiterreißwiderstand wird nach ASTM D624-B-91 (oder ISO 34, Methode C) bestimmt.

Die Reißfestigkeit wird nach DIN 53504-85S1 bestimmt.

Die Reißdehnung wird nach DIN 53504-85S1 bestimmt.

Die Shore-A-Härte wird nach DIN (Deutsche Industrie Norm) 53505 (Ausgabe August 2000) bestimmt.

Zugfestigkeit, Reißdehnung und Modul (Spannung bei 100% Dehung) wurden nach DIN 53504 (Ausgabe Mai 1994) an Probekörpern der Form S2 bestimmt .

### Beispiel 1

### a) Herstellung der Folie B1

Aus einem thermoplastischen, Harnstoffgruppen enthaltenden Siloxancopolymer mit einem Siloxangehalt von 92 Gew.%, einem gewichtsmittleren Molekulargewicht Mm von ca. 120 000 g/mol und einem Erweichungspunkt von ca. 125°C, wie es von der Wacker Chemie AG unter dem Handelsnamen GENIOMER® 140 erhältlich ist, wurde nach dem "chill roll"-Verfahren eine Folie hergestellt. Hierzu wurde der in Granulatform erhältliche Rohstoff mittels eines Schneckenextruders direkt auf die Kühlwalze ("chill roll") einer nachgeschalteten Walzenanlage extrudiert, wobei folgende Maschinenkonfiguration zum Einsatz kam:

Extrusion mittels 1-Schnecken-Extruder mit 10 Heizzonen:
Zone 1 (Einzug): 70°C
Zone 2 und 3: 170°C
Zone 4 bis 7: 195°C
Zone 8 und 9: 170°C
Zone 10 (Düse) 170°C
Drehzahl des Extruders: 30 UpM
Extrusionsrate: 50 kg/h
Regelbare Breitschlitzdüse, vertikale Düsenanordung, Breite ca. 60 cm;
Temperatur der Kühlwalze ("chill roll"): 15°C
Abzugsgeschwindigkeit: ca. 3,5 m/min.

Die Spaltweite der Breitschlitzdüse wurde dabei so eingestellt bzw, durch eine automatische Schichtdickenmessung so nachgeführt, dass sich eine Foliendicke von 0,38'mm ergab. Weiterhin enthielt die Walzenanlage eine Prägewalze, mit deren Hilfe die Folie mit einer speziellen Oberflächentextur versehen wurde. Die so hergestellte Folie wurde nach Zurechtschneiden auf eine Breite von 50 cm zu einer Folienrolle aufgerollt.

### b) Herstellung der Folie B2

Analog zur Herstellung von Folie B1 wurde durch Coextrusion ein PE-Folienlaminat mit dem thermoplastischen, Harnstoffgruppen enthaltenden Siloxancopolymer, das oben unter a) beschrieben ist, hergestellt.

Dazu wurde nach dem "chill roll"-Verfahren ein Folienlaminat hergestellt indem der in Granulatform erhältliche Siloxanrohstoff mittels eines Schneckenextruders direkt auf eine ebenfalls extrudierte LDPE Folie laminiert und über die Kühlwalze ("chili roll") einer nachgeschalteten Walzenanlage gefahren wurde, wobei folgende Maschinenkonfiguration zum Einsatz kam:

GENIOMER^{®}-Extrusion mittels 1-Schnecken-Extruder mit 10 Heizzonen:
Zone 1 (Einzug): 70°C
   Zone 2 und 3: 170°C
   Zone 4 bis 7: 195°C
   Zone 8 und 9: 170°C
   Zone 10 (Düse): 170°C
   Drehzahl des Extruders: 30 UpM
   Extrusionsrate: 50 kg/h
   Regelbare Breitschlitzdüse, vertikale DüsenanordiJng, Breite ca. 60 cm
   Temperatur der Kühlwalze ("chill roll"): 15°C
   Abzugsgeschwindigkeit: ca. 3,5 m/min.

LDPE-Extrusion mittels 1-Schnecken-Extruder mit 10 Heizzonen:
Zone 1 (Einzug): 70°C
Zone 2 und 3: 190°C
Zone 4 bis 7: 195°C
Zone 8 und 9: 180°C
Zone 10 (Düse) 175°C
Drehzahl des Extruders: 30 UpM
Extrusionsrate: 8 kg/h
Regelbare Breitschlitzdüse, vertikale Düsenanordung, Breite ca. 60 cm
Temperatur der Kühlwalze ("chill roll"): 15°C
Abzugsgeschwindigkeit: ca. 3,5 m/min.

Die Spaltweite der Breitschlitzdüse wurde dabei so eingestellt bzw. durch eine automatische Schichtdickenmessung so nachgeführt, dass sich eine Gesamtfoliendicke von 0,45 mm ergab. Weiterhin enthielt die Walzenanlage eine Prägewalze, mit deren Hilfe die GENIOMER^{®}-Schicht mit einer speziellen Oberflächentextur versehen wurde. Die so hergestellte Folie wurde nach Zurechtschneiden auf eine Breite von 50 cm zu einer Folienrolle aufgerollt.

Eine handelsübliche Solarzelle aus polykristallinem Silicium und mit der Abmessung 10 cm x 10 cm wurde mit der oben unter a) hergestellten thermoplastischen Siloxancopolymerfolie B1 vollständig bedeckt. Die Folie wurde anschließend leicht an die Solarzelle angedrückt, so dass etwaig zwischen Folie und Solarzelle eingeschlossene Luft vollständig entweichen konnte. Auf die thermoplastische Siloxancopolymerfolienschicht wurde nun eisenarmes Flachglas, wie es z.B. unter dem Handelsnamen AFG Solatex von der Fa. Interfloat Corporation, Liechtenstein, erhältlich ist, mit der Abmessung 10 cm x 10 cm und einer Dicke von 0,4 cm so aufgelegt und leicht an die Folienschicht angedrückt, dass etwaig zwischen Glas und Folie eingeschlossene Luftblasen vollständig entweichen konnten. Anschließend wurde das Sandwich unter Belastung mit einem Gewicht von 500 g im Heißluftofen für 15 Minuten bei 160°C erhitzt. Nach Entnahme aus dem Ofen und Abkühlen des Solarzellenlaminats wurde der von der Solarzelle generierte Stromfluss gemessen und verglichen.
Reine Solarzelle (100 qcm): 100 %
Solarzelle + eisenarmes Glas: 95 %
Solarzelle + thermoplastische Siloxancopolymerschicht B1 + eisenarmes Glas: 94 %

Die Solarzelle war mittels der thermoplastischen Siloxancopolymerschicht riss- und bruchfrei mit der Glasschicht verklebt. Der Verbund zwischen Glas, thermoplastischem Siloxancopolymer B1 und Solarzelle war völlig transparent (Transparenz der thermoplastischen Klebeschicht: ca. 99 %), blasenfrei und von hoher Festigkeit.

### Beispiel 2

Analog zu Beispiel 1 wurde ein Laminat hergestellt, welches zusätzlich zu den in Beispiel 1 genannten Schichten noch eine weitere Glasschicht und eine Schicht aus thermoplastischem Siloxancopolymer B1 enthielt, also folgenden formalen Aufbau besaß:
Eisenarmes Glas / thermoplastische Siloxancopolymerschicht B1 / Solarzelle / thermoplastische Siloxancopolymerschicht B1 / eisenarmes Glas.

Das so erhaltene Solarmodul mit laminatartigem Aufbau lieferte ebenfalls einen Strom, der 94 % des Stroms der unlaminierten, reinen Solarzelle (100 qcm) entsprach. Der Verbund zwischen Solarzelle und den Glasschichten war von hoher Festigkeit und ließ sich mechanisch nur noch mit extrem hohem Kraftaufwand und Zerstörung der Glasschichten trennen.

### Beispiel 3

Analog zu Beipiel 1 wurde unter zusätzlicher Verwendung einer PVF/PET/PVF-Colaminatfolie, wie sie beispielsweise unter dem Markennamen Icosolar®-2442 von der Fa. Isovolta AG erhältlich ist, mit einer Abmessung von 10 cm x 10 cm und einer Dicke von 0,35 mm ein Laminat mit folgendem formalen Aufbau hergestellt:
PVF/PET/PVF-Colaminatfolienschicht / thermoplastische Siloxancopolymerschicht B1 / Solarzelle / thermoplastische Siloxancopolymerschicht B1 / eisenarmes Glas.

Das so erhaltene Solarmodul mit laminatartigem Aufbau lieferte einen Strom, der 94 % des Stroms der unlaminierten, reinen Solarzelle (100 qcm) entsprach. Der Verbund zwischen Solarzelle und der PVF/PET/PVF-Colaminatfolie war von hoher Festigkeit und ließ sich mechanisch nur noch mit extrem hohem Kraftaufwand trennen.

### Beispiel 4

Analog zu Beispiel 1 wurde mit Hilfe eines Rollenlaminators und unter Verwendung dreier parallel nebeneinander liegender, handelsüblichen Solarzellenstrings, bestehend aus jeweils 12 Solarzellen (polykristallines Silizium, Abmessung je 10 x 10 cm), der unter 1b) hergestellten thermoplastischen Siloxancopolymerfolie B2, einer einseitig coronabehandelten PE/PTFE-Copolymerfolie, wie sie beispielsweise unter dem Markennamen Fluon® ETFE bei der Asahi Glass Co., Ltd., Japan, erhältlich ist, sowie einer zusätzlichen PVF/PET/PVF-Colaminatfolie, wie sie beispielsweise unter dem Markennamen Icosolar®-2442 von der Fa. Isovolta AG erhältlich ist, ein Laminat mit dem formalen Aufbau Fluor® ETFE / thermoplastische Siloxancopolymerschicht B2' / Solarzellenstring / thermoplastische Siloxancopolymerschicht B2' / PVF/PET/PVF-Colaminatfolie hergestellt. Dabei kam die coronabehandelte Seite der PE/PTFE-Copolymerfolie so zu liegen, dass sie auf die Seite der thermoplastischen Siloxancopolymerschicht wies. Weiterhin wurde vor Eintritt in den Rollenlaminator der LDPE-Anteil der unter 1b) beschriebenen GENIOMER®-Coextrusionsfolie B2 beim Abwickeln von der Folienrolle über eine Umlenkrolle entfernt (B2'). Die Temperatur der Laminierrollen betrug 160°C, die Rollen hatten einen Spaltabstand von 1,2 mm, und die Vorschubgeschwindigkeit des Rollenlaminators betrug 0,15 m/min, so dass das erfindungsgemäße Laminat mit einer Breite von 50 cm und einer Länge von ca. 130 cm in etwa 9 Minuten hergestellt werden konnte.

Das so erhaltene Solarmodul mit laminatartigem Aufbau lieferte einen Strom, der 94 % des Stroms der unlaminierten, reinen Solarzellenstrings (3600 qcm) entsprach. Der Verbund zwischen den einzelnen Schichten war von hoher Festigkeit und ließ sich mechanisch nur noch mit extrem hohem Kraftaufwand trennen.

## Patentansprüche

1. Laminat umfassend
(A) mindestens eine Schicht enthaltend anorganisches und/oder organisches Glas,
(B) mindestens eine Schicht enthaltend ein thermoplastisches Siloxancopolymer,
(C) mindestens eine Einheit enthaltend mindestens eine photosensitive Schicht,
und gegebenenfalls
(D) mindestens eine weitere Schicht ausgewählt aus der Gruppe enthaltend organische Polymere, siliciumorganische Polymere, metallische Werkstoffe, mineralische Werkstoffe und Holz.

2. Laminat gemäß Anspruch 1, **dadurch gekennzeichnet, dass** es sich bei dem thermoplastischen Siloxancopolymer der Schicht (B) um Verbindungen der allgemeinen Formel 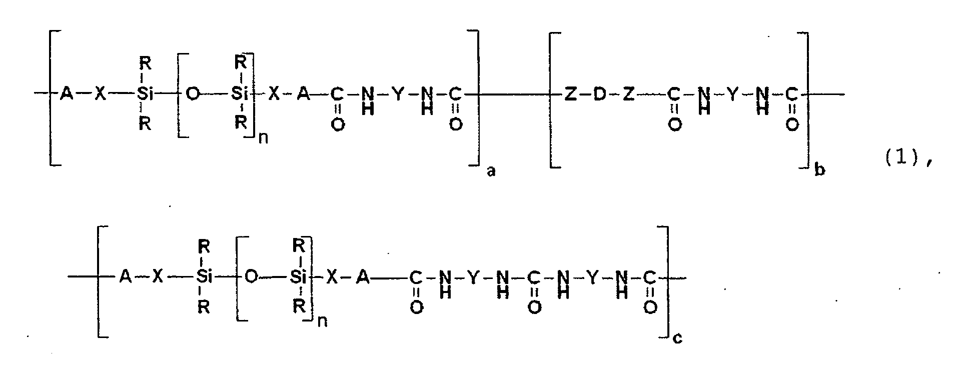 handelt, wobei
R gleich oder verschieden sein kann und einen einwertigen, Sigebundenen, gegebenenfalls durch Halogenatome substituierten Kohlenwasserstoffrest, der durch Sauerstoffatome unterbrochen sein kann, darstellt,
X gleich oder verschieden sein kann und einen Alkylenrest mit 1 bis 20 Kohlenstoffatomen, in dem einander nicht benachbarte Methyleneinheiten durch Gruppen -O- ersetzt sein können, bedeutet,
A gleich oder verschieden sein kann und ein Sauerstoffatom oder eine Aminogruppe -NR¹- bedeutet,
Z gleich oder verschieden sein kann und ein Sauerstoffatom oder eine Aminogruppe -NR'- bedeutet,
R' gleich oder verschieden sein kann und Wasserstoffatom oder einen Alkylrest mit 1 bis 10 Kohlenstoffatomen bedeutet,
Y gleich oder verschieden sein kann und einen zweiwertigen, gegebenenfalls durch Halogenatome substituierten Kohlenwasserstoffrest mit 1 bis 20 Kohlenstoffatomen, der durch Sauerstoffatome unterbrochenen sein kann, bedeutet,
D gleich oder verschieden sein kann und einen zweiwertigen, gegebenenfalls durch Halogenatome oder C₁-C₆-Alkylester-Gruppen substituierten Kohlenwasserstoffrest bedeutet, in dem einander nicht benachbarte Methyleneinheiten durch Gruppen -O-, -COO-, -OCO- oder -OCOO- ersetzt sein können,
n gleich oder verschieden sein kann und eine Zahl von 1 bis 4000 ist,
a eine Zahl von mindestens 1 ist,
b 0 oder eine Zahl von 1 bis 1000 ist und
c 0 oder eine Zahl von 1 bis 1000 ist.

3. Laminat gemäß Anspruch 1 oder 2, **dadurch gekennzeichnet, dass** das thermoplastische Siloxancopolymer der Schicht (B) bei dem Druck der umgebenden Atmosphäre, also zwischen 900 und 1100 hPa, einen Erweichungspunkt von mindestens 40°C hat.

4. Laminat gemäß einem oder mehreren der Ansprüche 1 bis 3, **dadurch gekennzeichnet, dass** das thermoplastische Siloxancopolymer der Schicht (B) bei dem Druck der umgebenden Atmosphäre, also zwischen 900 und 1100 hPa, einen Erweichungspunkt von 100 bis 180°C aufweist.

5. Laminat gemäß einem oder mehreren der Ansprüche 1 bis 4, **dadurch gekennzeichnet, dass** der E-Modul des thermoplastischen Copolymeren bei 100 % Dehnung bei Raumtemperatur bei Werten von bis zu 3 N/mm² liegt.

6. Laminat gemäß einem oder mehreren der Ansprüche 1 bis 5, **dadurch gekennzeichnet, dass** Schicht (D) ausgewählt ist aus der Gruppe bestehend aus metallischen Werkstoffen, mineralischen Werkstoffen, organischen und siliciumorganischen Polymeren sowie deren Mischungen, Copolymere und Laminate.

7. Laminat gemäß einem oder mehreren der Ansprüche 1 bis 6, **dadurch gekennzeichnet, dass** es mindestens eine Schicht (D) aufweist.

8. Verfahren zur Herstellung der Laminate gemäß einem oder mehreren der Ansprüche 1 bis 7, **dadurch gekennzeichnet, dass**
in einem 1. Schritt Schicht (B) aus einem thermoplastischen Siloxancopolymer sowie gegebenenfalls weiteren Zusätzen in Form einer Folie hergestellt wird,
in einem 2. Schritt die im 1. Schritt erhaltene Folienschicht (B) zwischen die zu laminierenden Schichten (A) und (C) sowie gegebenenfalls (C) und (D) gebracht wird und
in einem 3. Schritt die einzelnen Schichten zu einem Laminat verbunden werden.

9. Verfahren nach Anspruch 8, **dadurch gekennzeichnet, dass** der 3. Schritt bei einer Temperatur, die 10 bis 50°C über der Erweichungstemperatur des verwendeten thermoplastischen Siloxancopolymers liegt, und einem Druck, der zwischen dem Druck der umgebenden Atmosphäre, also ca. 1000 hPa, und 20 000 hPa liegt, durchgeführt wird.

## Claims

1. Laminate comprising
(A) at least one layer containing inorganic and/or organic glass,
(B) at least one layer containing a thermoplastic siloxane copolymer,
(C) at least one unit containing at least one photosensitive layer
and optionally
(D) at least one further layer selected from the group consisting of organic polymers, organosilicon polymers, metallic materials, mineral materials and wood.

2. Laminate according to Claim 1, **characterized in that** the thermoplastic siloxane copolymer of layer (B) is comprised of compounds of the general formulae 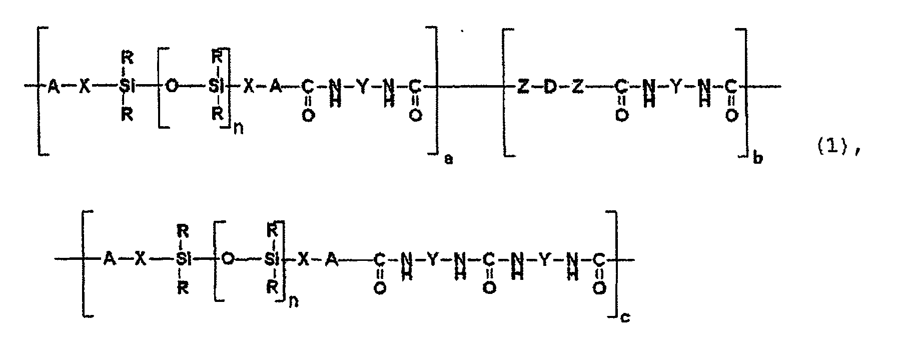 in which
R may be identical or different and is a monovalent, Si-bonded hydrocarbon radical which is optionally substituted by halogen atoms and may be interrupted by oxygen atoms,
X may be identical or different and is an alkylene radical having 1 to 20 carbon atoms, in which non-neighboring methylene units may be replaced by -O- groups,
A may be identical or different and is an oxygen atom or an amino group -NR'-,
Z may be identical or different and is an oxygen atom or an amino group -NR'-,
R' may be identical or different and is a hydrogen atom or an alkyl radical having 1 to 10 carbon atoms,
Y may be identical or different and is a divalent hydrocarbon radical which has 1 to 20 carbon atoms, is optionally substituted by halogen atoms and may be interrupted by oxygen atoms,
D may be identical or different and is a divalent hydrocarbon radical which is optionally substituted by halogen atoms or C₁-C₆-alkyl ester groups and in which non-neighboring methylene units may be replaced by -O-, -COO-, -OCO- or -OCOO- groups,
n may be identical or different and is a number from 1 to 4000,
a is a number from at least 1,
b is 0 or a number from 1 to 1000 and
c is 0 or a number from 1 to 1000.

3. Laminate according to Claim 1 or 2, **characterized in that** the thermoplastic siloxane copolymer of the layer (B) has a softening point of at least 40°C at the pressure of the ambient atmosphere, i.e. from 900 to 1100 hPa.

4. Laminate according to one or more of Claims 1 to 3, **characterized in that** the thermoplastic siloxane copolymer of the layer (B) has a softening point of from 100 to 180°C at the pressure of the ambient atmosphere, i.e. from 900 to 1100 hPa.

5. Laminate according to one or more of Claims 1 to 4, **characterized in that** the modulus of elasticity of the thermoplastic copolymer has values of up to 3 N/mm² at 100% elongation at room temperature.

6. Laminate according to one or more of Claims 1 to 5, **characterized in that** layer (D) is selected from the group consisting of metallic materials, mineral materials, organic and organosilicon polymers and mixtures, copolymers and laminates thereof.

7. Laminate according to one or more of Claims 1 to 6, **characterized in that** it has at least one layer (D).

8. Process for the production of the laminates according to one or more of Claims 1 to 7, **characterized in that**
in a lst step layer (B) is produced from a thermoplastic siloxane copolymer and optionally further additives in the form of a film,
in a 2nd step the film layer (B) obtained in the 1st step is placed between the layers (A) and (C) and optionally (C) and (D) to be laminated, and
in a 3rd step the individual layers are bonded to give a laminate.

9. Process according to Claim 8, **characterized in that** the 3rd step is carried out at a temperature which is from 10 to 50°C above the softening temperature of the thermoplastic siloxane copolymer used and at a pressure which is from the pressure of the ambient atmosphere, i.e. about 1000 hPa, to 20 000 hPa.

## Revendications

1. Stratifié comprenant
(A) au moins une couche contenant du verre organique et/ou inorganique,
(B) au moins une couche contenant un copolymère siloxane thermoplastique,
(C) au moins une unité contenant au moins une couche photosensible,
et éventuellement
(D) au moins une autre couche choisie dans le groupe contenant des polymères organiques, des polymères organosiliciés, des matériaux métalliques, des matériaux minéraux et le bois.

2. Stratifié selon la revendication 1, **caractérisé en ce que** le copolymère siloxane thermoplastique de la couche (B) consiste en des composés de formule générale 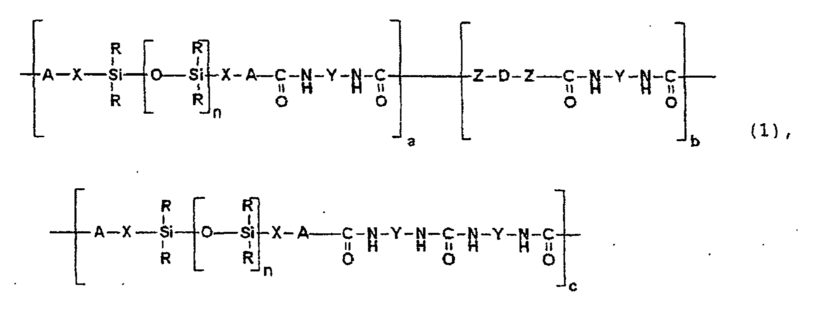 dans laquelle
R peut être le même ou différent et représente un radical hydrocarboné monovalent lié au silicium, éventuellement substitué par des atomes d'halogène, qui peut être interrompu par des atomes d'oxygène,
X peut être le même ou différent et représente un radical alkylène ayant de 1 à 20 atomes de carbone, dans lequel des groupes méthylène non contigus peuvent être remplacés par des groupes -O-,
A peut être le même ou différent et représente un atome d'oxygène ou un groupe amino -NR'-,
Z peut être le même ou différent et représente un atome d'oxygène ou un groupe amino -NR'-,
R' peut être le même ou différent et représente un atome d'hydrogène ou un radical alkyle ayant de 1 à 10 atomes de carbone,
Y peut être le même ou différent et représente un radical hydrocarboné divalent ayant de 1 à 20 atomes de carbone, éventuellement substitué par des atomes d'halogène, qui peut être interrompu par des atomes d'oxygène,
D peut être le même ou différent et représente un radical hydrocarboné divalent éventuellement substitué par des atomes d'halogène ou des groupes ester alkylique en C₁-C₆, dans lequel des groupes méthylène non contigus peuvent être remplacés par des groupes - O-, -COO-, -OCO- ou -OCOO-,
n peut être le même ou différent et est un nombre de 1 à 4 000,
a est un nombre valant au moins 1,
b est 0 ou un nombre de 1 à 1 000 et
c est 0 ou un nombre de 1 à 1 000.

3. Stratifié selon la revendication 1 ou 2,
**caractérisé en ce que** le copolymère siloxane thermoplastique de la couche (B) a sous la pression de l'atmosphère environnante, c'est-à-dire entre 900 et 1 100 hPa, un point de ramollissement d'au moins 40 °C.

4. Stratifié selon une ou plusieurs des revendications 1 à 3, **caractérisé en ce que** le copolymère siloxane thermoplastique de la couche (B) a sous la pression de l'atmosphère environnante, c'est-à-dire entre 900 et 1 100 hPa, un point de ramollissement de 100 à 180 °C.

5. Stratifié selon une ou plusieurs des revendications 1 à 4, **caractérisé en ce que** le module d'élasticité du copolymère thermoplastique à un allongement de 100 % à la température ambiante se situe à des valeurs allant jusqu'à 3 N/mm².

6. Stratifié selon une ou plusieurs des revendications 1 à 5, **caractérisé en ce que** la couche (D) est choisie dans le groupe constitué par des matériaux métalliques, des matériaux minéraux, des polymères organiques et des polymères organosiliciés ainsi que des mélanges, des copolymères et des stratifiés de ceux-ci.

7. Stratifié selon une ou plusieurs des revendications 1 à 6, **caractérisé en ce qu'**il comporte au moins une couche (D).

8. Procédé pour la fabrication des stratifiés selon une ou plusieurs des revendications 1 à 7, **caractérisé en ce que**
dans une 1^{ère} étape on produit sous forme d'un film une couche (B) à base d'un copolymère siloxane thermoplastique ainsi qu'éventuellement d'autres additifs,
dans une 2^{e} étape on place la couche sous forme de film (B) obtenue dans la 1^{ère} étape entre les couches (A) et (C) ainsi qu'éventuellement (C) et (D) à stratifier et
dans une 3^{e} étape on assemble les couches individuelles en un stratifié.

9. Procédé selon la revendication 8, **caractérisé en ce que** la 3^{e} étape est effectuée à une température qui se situe à 10-50 °C au-dessus de la température de ramollissement du copolymère siloxane thermoplastique utilisé, et sous une pression qui se situe entre la pression de l'atmosphère environnante, c'est-à-dire d'environ 1 000 hPa, et 20 000 hPa.
